(19) Europäisches Patentamt
European Patent Office
Office européen des brevets

(11) Veröffentlichungsnummer: **0 260 729 B1**

(12) **EUROPÄISCHE PATENTSCHRIFT**

(45) Veröffentlichungstag der Patentschrift: **24.04.91**

(51) Int. Cl.⁵: **G01P 3/68**, G01P 5/18

(21) Anmeldenummer: **87201415.4**

(22) Anmeldetag: **23.07.87**

(54) **Verfahren zur Bestimmung der Transportgeschwindigkeit von Schaltungsplatten in Lötvorrichtungen sowie Transportvorrichtung zur Durchführung dieses Verfahrens.**

(30) Priorität: **22.08.86 DE 3628568**

(43) Veröffentlichungstag der Anmeldung:
**23.03.88 Patentblatt 88/12**

(45) Bekanntmachung des Hinweises auf die
Patenterteilung:
**24.04.91 Patentblatt 91/17**

(84) Benannte Vertragsstaaten:
**DE FR GB**

(56) Entgegenhaltungen:
**DE-A- 2 531 142**
**US-A- 3 590 201**
**US-A- 4 180 199**

**PRODUCT ENGINEERING, Band 38, Nr. 22, 23. Oktober 1967, Seite 75; "Liquid level"**

(73) Patentinhaber: **Philips Patentverwaltung GmbH**
**Wendenstrasse 35 Postfach 10 51 49**
**W-2000 Hamburg 1(DE)DE**

Patentinhaber: **N.V. Philips' Gloeilampenfabrieken**
**Groenewoudseweg 1**
**NL-5621 BA Eindhoven(NL)FR GB**

(72) Erfinder: **Gumbert, Hans**
**Ballersbacherweg 30**
**W-6349 Sinn/Dillkreis(DE)**

(74) Vertreter: **Kupfermann, Fritz-Joachim, Dipl.-Ing. et al**
**Philips Patentverwaltung GmbH Wendenstrasse 35 Postfach 10 51 49**
**W-2000 Hamburg 1(DE)**

**Beschreibung**

Die Erfindung bezieht sich auf ein Verfahren zur Bestimmung der Transportgeschwindigkeit von Schaltungsplatten im Lötbereich von Lötvorrichtungen, wobei die Schaltungsplatte provisorisch bestückt ist mit Bauelementen, deren elektrische Verbindungsteile in einem Lötbad mit Lötwelle mit Leitungszügen der Schaltungsplatten verlötet werden, wobei die Schaltungsplatten an Trägern festgehalten werden und wobei jeder Träger mit wenigstens einer Meßvorrichtung zusammenwirkt, von der meßbare Werte von in einer Durchkontaktierung hochsteigendem flüssigen Lot ermittelt werden, sowie auf eine Transportvorrichtung und eine Schaltungsplatte zur Durchführung dieses Verfahrens.

Das Verlöten von elektrischen Schaltungsplatten mit Bauelementen, die zuvor auf die Platten provisorisch aufgesteckt oder aufgeklebt wurden, erfolgt bei Großserien mechanisiert auf Lötstraßen. Die einzelnen Schaltungsplatten werden längs dieser Lötstraße mit Hilfe von sie festklemmenden Trägern mittels eines Förderbandes transportiert. Zunächst werden die Schaltungsplatten dabei in einem Flußmittelbad mit Flußmittel besprüht. Im Anschluß daran wird das Flußmittel getrocknet. Im weiteren Transportverlauf werden die Schaltungsplatten mittels ihrer Träger schräg nach oben ansteigend gefördert; dabei kommen die Schaltungsplatten mit einer Lötwelle in Berührung.

Für einen einwandfreien Lötvorgang ist es wichtig, daß die Schleppgeschwindigkeit der Schaltungsplatten über die Lötwelle möglichst genau an die Lötbedingungen angepaßt ist. Erfolgt das Transportieren zu langsam, dann kann es zu Verbrennungen führen; erfolgt das Transportieren zu schnell, dann ergeben sich erfahrungsgemäß Kaltlötstellen oder überhaupt nicht gelötete Lötstellen.

Ein Verfahren zur Bestimmung du Transportgeschwindigkeit von Schaltungsplatten mit den Merkmalen des ersten Teiles von Anspruch 1 ist aus US-A- 4 180 199 bekannt.

Es ist aus der deutschen Patentschrift 25 31 142 bekannt, mit Hilfe einer Meßeinrichtung denjenigen Zeitpunkt zu messen, an dem das in einer Durchkontaktierung einer Schaltungsplatte hochsteigende flüssige Lot am oberen Ende der Durchkontaktierung ankommt. Dazu werden Meßsonden eingesetzt, die einen elektrischen Kontakt signalisieren, wenn die Unterseite der Leiterplatte mit dem Lotbad in Berührung kommt und wenn das Lot in der Durchkontaktierung eine bestimmte Steighöhe erreicht.Mit Hilfe des Verfahrens nach der deutschen Patentschrift 25 31 142 läßt sich ermitteln, von welchem Zeitpunkt an nach dem Ätzen der Schaltungsplatte günstige Lötergebnisse zu erzielen sind.

Es ist Aufgabe der Erfindung, ein Verfahren zum Verlöten von elektrischen Schaltungsplatten mit Bauelementen anzugeben, mit dem die für jede einzeln zu handhabende Schaltungsplatte günstigste Transportgeschwindigkeit während des Lötens eingestellt werden kann.

Die gestellte Aufgabe ist erfindungsgemäß dadurch gelöst, daß mittels einer Lichtquelle ein gebündelter Lichtstrahl auf die Durchkontaktierung abgestrahlt wird, dessen Reflexion ermittelt wird in den Augenblicken, in denen das Lot der Lötwelle zunächst den unteren Endbereich und darauf den oberen Endbereich der Durchkontaktierung erreicht, und daß in einem Rechner die Zeitdifferenz zwischen den Messungen und daraus die geeignete Transportgeschwindigkeit der Schaltungsplatte bestimmt wird.

Aus der Differenz zwischen den Zeiten, in denen der Lotspiegel einerseits am unteren Endbereich einer Durchkontaktierung angelangt ist und andererseits in der Durchkontaktierung hochgestiegen ist in deren oberen Endbereich erreicht hat, läßt sich feststellen, ob die Schleppgeschwindigkeit richtig eingestellt, zu langsam oder zu schnell ist. Es zeigt sich, daß bei dem Einstellen der richtigen Transportgeschwindigkeit für jede einzelne Schaltungsplatte bessere Lötergebnisse erzielt werden. Insbesondere kann die Zahl der bisher inmer noch üblichen Nachbearbeitungsplätze w esentlich reduziert werden. Das Verzundern der Sondenspitzen entfällt völlig, und die Meßvorrichtung wird bedeutend zuverlässiger, da sie berührungslos arbeitet.

Die Genauigkeit der Messung läßt sich noch dadurch erhöhen, wenn nach einer weiteren Ausgestaltung der Erfindung mit einer weiteren Meßsonde die Temperatur der Schaltungsplatte selbst gemessen wird. Auch die gemessenen Temperaturwerte der Schaltungsplatte gehen in die vom Rechner zu bestimmende Transportgeschwindgkeit über die Lötwelle ein.

Zur Durchführung des Verfahrens zur Bestimmung der Transportgeschwindigkeit ist eine Transportvorrichtung vorgesehen, die dadurch gekennzeichnet ist, daß der Träger eine Lichtquelle für bündelbares Licht aufweist, von der ein Lichtstrahl in die Durchkontaktierung abgegeben wird, und daß Fotosensoren vorgesehen sind, die im Lot im Bereich der Durchkontaktierung reflektiertes Licht detektieren. Mittels dieser Transportvorrichtung ist eine einwandfreie berührungslose Messung zur Bestimmung der Transportgeschwindigkeit möglich. Das Lötergebnis wird verbessert, wenn eine zusätzliche Temperaturmeßsonde auf die Schaltungsplatte aufsetzbar ist.

Es ist vorteilhaft, wenn alle Meßvorrichtungen gleichzeitig ihre Meßwerte abgeben. Nach einer weiteren Ausgestaltung der Erfindung ist deshalb vorgesehen, daß alle Meßvorrichtungen in einer Reihe quer zur Transportrichtung angeordnet sind.

Schaltungsplatten, die für die Transportvorrichtung eingerichtet sind, sollten vorteilhafterweise in besonderer Weise an den Meßaufbau angepaßt sein. Nach einer weiteren Ausgestaltung der Erfindung ist deshalb vorgesehen, daß am in Transportrichtung vorn befindlichen Rand der Schaltungsplatte wenigstens eine Blinddurchkontaktierung für Strahlreflexion vorgesehen ist, wobei die Blinddurchkontaktierung in Transportrichtung so weit vor dem beschalteten Teil der Schaltungsplatte angeordnet ist, daß die Transportgeschwindigkeit neu eingestellt ist, wenn der beschaltete Teil die Lötwelle erreicht.

Sobald die Verlötung der beschalteten Plattenteile beginnt, ist dann die Transportvorrichtung auf die richtige Transportgeschwindigkeit eingestellt.

Die Erfindung wird anhand des in der Zeichnung dargestellten Ausführungsbeispieles näher erläutert. Es zeigen:

Fig. 1 eine Transportvorrichtung für eine Schaltungsplatte mit einer Meßvorrichtung für berührungslose Geschwindigkeitsmessung,

Fig. 2 eine vergrößerte Darstellung der Geschwindigkeitsmeßvorrichtung.

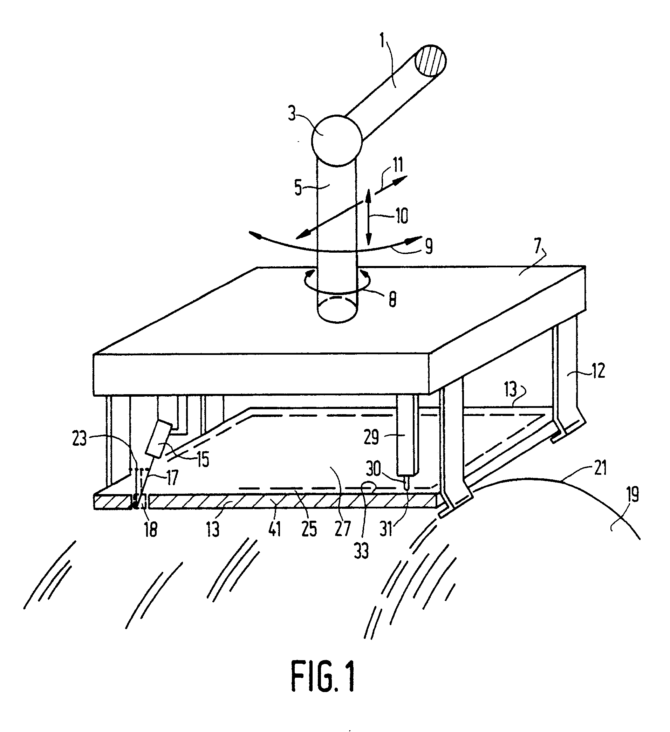

Fig. 1 zeigt einen Greifarm 1, der der gelenkige Arm eines Roboters sein kann. Dieser Greifarm 1 weist ein Gelenk 3 auf, welches über eine Tragstange 5 einen Träger 7 bewegen kann. Das Gelenk 3 kann den Träger 7 in Richtung eines Doppelpfeiles 8 verdrehen und in Richtung eines Doppelpfeiles 9 verkippen. Weiterhin kann der Arm 1 den Träger 7 mit seiner Tragstange 5 über das Gelenk 3 in Richtung eines Doppelpfeiles 10 heben und senken und ihn schließlich in Richtung eines Doppelpfeiles 11 (in Transportrichtung) verfahren.

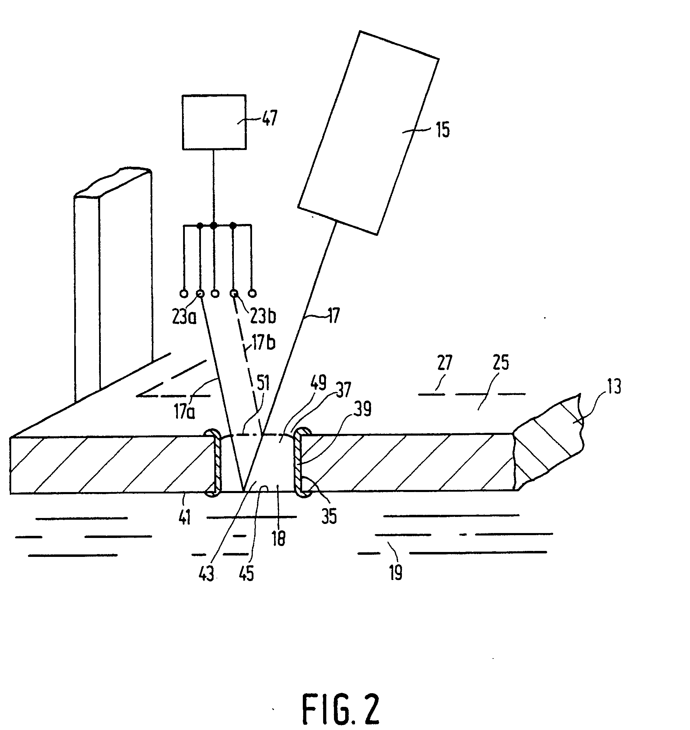

Der Träger 7 ist mit Greifbacken 12 versehen, die eine Schaltungsplatte 13 ergreifen können. An dem Träger 7 ist eine Lichtquelle 15 für modulierbares und bündelbares Licht, beispielsweise Laserlicht, befestigt. Von dieser Lichtquelle 15 wird ein Lichtstrahl 17 auf eine Blinddurchkontaktierung 18 gestrahlt. Der Lichtstrahl wird am Lot 19 einer Lötwelle 21 reflektiert zu Fotosensoren 23. Die Blinddurchkontaktierung 18, die aus Fig. 2 deutlicher zu entnehmen ist, befindet sich in einem Randbereich 25 der Schaltungsplatte 13. Innerhalb des Randbereiches 25 der Schaltungsplatte 13 befindet sich der beschaltete Teil 27 der Schaltungsplatte 13.

Am Träger 7 ist eine Temperaturmeßsonde 29 vorgesehen, die einen Meßfühler 30 trägt, der mit seiner Meßspitze 31 auf die Oberseite 33 der Schaltungsplatte 13 aufsetzbar ist. Mit dieser Temperaturmeßsonde wird die Oberflächentemperatur der Schaltungsplatte 13 gemessen.

Fig. 2 zeigt in vergrößerter Darstellung die Blinddurchkontaktierung 18 der Schaltungsplatte 13. Die Wandung 35 eines Durchbruches 37 ist dabei mit einer Metallisierung 39 versehen. Die Lichtquelle 15 strahlt den Lichtstrahl 17 in die Blinddurchkontaktierung hinein.

Steigt das Lot 19 beim Transport der Schaltungsplatte über die Lötwelle gegen die Unterseite 41 der Schaltungsplatte an, dann bildet sich im unteren Endbereich 43 der Blinddurchkontaktierung 18 ein unterer Lotspiegel 45 (durchgezogene Linie) aus. An diesem Lotspiegel 45 reflektiert der Lichtstrahl 17. Der Reflexionslichtstrahl 17a (durchgezogene Linie) fällt auf einen (23a) der Fotosensoren 23. Das vom Fotosensor 23a empfangene Lichtsignal wird als Zeitsignal einem Rechner 47 zugeleitet. Steigt das Lot 19 in der Durchkontaktierung 18 an und erreicht es den oberen Endbereich 49 der Durchkontaktierung (angedeutet durch die gestrichelte Linie 51), dann reflektiert der Lichtstrahl 17 als Lichtstrahl 17b am oberen Lotspiegel 53 zum Fotosensor 23b. Das vom Fotosensor 23b empfangene Lichtsignal wird als Zeitsignal dem Rechner 47 zugeführt. Dieser ermittelt die Zeitdifferenz zwischen beiden Zeitsignalen und stellt nach Maßgabe dieses Differenzwertes die Geschwindigkeit ein, mit der der Träger die Schaltungsplatte 13 über die Lotwelle 21 hinwegschleppt. In die Transportgeschwindigkeit geht auch noch der Temperaturmeßwert der Temperaturmeßsonde 29 ein. Es werden auf diese Weise in der Qualität gute Lötergebnisse erzielt.

In den Zeichnungen soll der vorn dargestellte Rand 25 auch in Transportrichtung der vordere Rand sein. Die Blinddurchkontaktierung 18 ist in Transportrichtung so weit vor dem beschalteten Teil 27 der Schaltungsplatte 13 vorgesehen, daß die Transportgeschwindigkeit neu eingestellt ist, wenn der beschaltete Teil 27 von der Lotwelle 21 erreicht wird.

## Ansprüche

1. Verfahren zur Bestimmung der Transportgeschwindigkeit von Schaltungsplatten im Lötbereich von Lötvorrichtungen, wobei die Schaltungsplatten provisorisch bestückt sind mit Bauelementen, deren elektrische Verbindungsteile in einem Lötbad mit Lötwelle mit Leitungszügen der Schaltungsplatten verlötet werden, wobei die Schaltungsplatten an Trägern festgehalten werden und wobei jeder Träger mit wenigstens einer Meßvorrichtung zusammenwirkt, von der meßbare Werte von in einer Durchkontaktierung hochsteigendem flüssigem Lot ermittelt werden, dadurch gekennzeichnet, daß mittels einer Lichtquelle ein gebündelter Lichtstrahl auf eine nicht mit einem Bauelement bestückte Durchkontaktierung abgestrahlt wird, dessen Reflexion in den Augenblicken, in denen das Lot der Lötwelle zunächst den unteren Endbereich und darauf den oberen Endbereich der Durchkontaktierung erreicht, jeweils in einem zugeordneten Fotosensor ein Signal auslöst und daß in einem Rechner die Zeitdifferenz zwischen den Signalen und daraus die geeignete Transportgeschwindigkeit der Schaltungsplatte bestimmt wird.

2. Verfahren nach Anspruch 1, dadurch gekennzeichnet, daß mit einer Meßsonde die Temperatur der Schaltungsplatte selbst gemessen wird.

3. Transportvorrichtung zur Durchführung des Verfahrens nach den Ansprüchen 1 und 2, dadurch gekennzeichet, daß der Träger (7) eine Lichtquelle (15) für bündelbares Licht aufweist, von der ein gebündelter Lichtstrahl (17) in die Durchkontaktierung abgegeben wird, und daß Fotosensoren (23) vorgesehen sind, die am Lot im Bereich der Durchkontaktierung (18) reflektiertes Licht (17a, 17b) detektieren.

4. Transportvorrichtung nach Anspruch 3, dadurch gekennzeichnet, daß wenigstens ein Fotosensor (23a) vorgesehen ist für einen im unteren Endbereich (43) der Durchkontaktierung (18) am Lotspiegel (45) reflektiertes Licht und ein Fotosensor (23b) für einen im oberen Endbereich der Durchkontaktierung (18) am Lotspiegel (53) reflektiertes Licht.

5. Transportvorrichtung nach Anspruch 3, dadurch gekennzeichnet, daß als Bestandteil der Meßvorrichtung eine Temperaturmeßsonde (29) auf die Schaltungsplatte (13) aufsetzbar ist.

6. Transportvorrichtung nach den Ansprüchen 3 bis 5, dadurch gekennzeichnet, daß alle Meßvorrichtungen (15/23, 29) quer zur Transportrichtung in einer Reihe angeordnet sind.

7. Schaltungsplatte, die für die Transportvorrichtung nach den Ansprüchen 4 bis 6 und das Verfahren nach den Ansprüchen 1 und 2 eingerichtet ist, dadurch gekennzeichnet, daß am in Transportrichtung vorn befindlichen Rand (25) der Schaltungsplatte (13) wenigstens eine Blinddurchkontaktierung (18) für Strahlreflexion vorgesehen ist, wobei die Blinddurchkontaktierung in Transportrichtung so weit vor dem beschalteten Teil (27) der Schaltungsplatte (13) angeordnet ist, daß die Transportgeschwindigkeit neu eingestellt ist, wenn der beschaltete Teil (27) die Lötwelle (19) erreicht.

## Claims

1. A method of determining the speed of transport of circuit boards at the soldering area of soldering devices, in which the circuit boards are provisionally provided with elements, whose electrical connection parts are soldered in a soldering bath with a soldering wave to series of leads of the circuit board, the circuit boards being held at supports and each support cooperating with at least one measuring device, by which measurable values of a liquid solder rising in a feedthrough are determined, characterized in that by means of a light source a concentrated light beam is thrown onto a feedthrough, not provided with an element, whose reflection produces at the instants at which the solder of the soldering wave reaches first the lower end region and then the upper end region of the feedthrough each time a signal in an associated photosensor, and in that in a computer the time difference between the signals is determined and therefrom the suitable speed of transport of the circuit board is determined.

2. A method as claimed in Claim 1, characterized in that by means of a measuring probe the temperature of the circuit board itself is measured.

3. A transport device for carrying out the method claimed in Claims 1 and 2, characterized in that the support (7) has a light source (15) for light that can be concentrated, by which a concentrated light beam (17) is thrown onto the feedthrough and in that photosensors (23) are provided, which detect light (17a, 17b) reflected at the solder at the area of the feedthrough.

4. A transport device as claimed in Claim 3, characterized in that at least one photosensor (23a) is provided for a light beam reflected in the lower end region (43) of the feedthrough (18) at the solder level (45) and a photosensor (23b) is provided for a light beam reflected in the upper end region of the feedthrough (18) at the solder level (53).

5. A transport device as claimed in Claim 3, characterized in that as component part of the measuring device a temperature measuring probe (29) can be placed on the circuit board (13).

6. A transport device as claimed in Claims 3 to 5, characterized in that all measuring devices (15/23, 29) are arranged in a row transverse to the direction of transport.

7. A circuit board designed for the transport device claimed in Claims 3 to 6 and for the method claimed in Claims 1 and 2, characterized in that at the edge (25) of the circuit board (13) situated in the front position in the direction of transport at least one dummy feedthrough (18) for beam reflection is provided, the dummy feedthrough being arranged in the direction of transport at such a distance in front of the wired part (27) of the circuit board (13) that the speed of transport is readjusted when the wired part (27) reaches the soldering wave (19).

**Revendications**

1. Procédé pour déterminer la vitesse de transport de circuits imprimés dans le domaine de soudure de dispositifs de soudure, dans lequel les circuits imprimés sont pourvus de composants fixés provisoirement, dont les éléments de connexion électrique sont soudés aux voies de connexion des circuits imprimés dans un bain de soudure à vague de soudure, les circuits imprimés étant retenus par des supports et chaque support coopérant avec au moins un dispositif de mesure, qui détermine des valeurs mesurables sur une soudure liquide qui remonte dans un trou traversant de contact, caractérisé en ce qu'une source lumineuse émet vers le trou traversant de contact non pourvu d'un composant, un faisceau de rayons lumineux, dont la réflexion aux instants respectifs auxquels la vague de soudure atteint d'abord la zone d'extrémité inférieure et ensuite, la zone d'extrémité supérieure du trou traversant de contact déclenche chaque fois un signal dans un capteur photosensible associé et que la différence de temps entre les signaux et, à partir de celle-ci, la vitesse de transport appropriée du circuit imprimé, sont déterminées dans un ordinateur.

2. Procédé suivant la revendication 1, caractérisé en ce que la température du circuit imprimé lui-même est mesurée à l'aide d'une sonde de mesure.

3. Dispositif de transport pour l'exécution du procédé suivant les revendications 1 et 2, caractérisé en ce que le support (7) comporte une source lumineuse (15) de lumière pouvant être concentrée en faisceau qui émet un faisceau lumineux (17) vers le trou traversant de contact et que sont prévus des capteurs photosensibles (23) qui détectent la lumière (17a, 17b) réfléchie par la soudure dans la zone du trou traversant de contact (18).

4. Dispositif de transport suivant la revendication 3, caractérisé en ce qu'au moins un capteur photosensible (23a) est prévu pour de la lumière réfléchie par le miroir de soudure (45) dans la zone d'extrémité inférieure (43) du trou traversant de contact (18), de même qu'un capteur photosensible (23b) pour de la lumière réfléchie par le miroir de soudure (53) dans la zone d'extrémité supérieure du trou traversant de contact (18).

5. Dispositif de transport suivant la revendication 3, caractérisé en ce que le dispositif de mesure comporte une sonde de mesure de température (29) qui peut être placée sur le circuit imprimé (13).

6. Dispositif de transport suivant les revendications 3 à 5, caractérisé en ce que tous les dispositifs de mesure (15/23, 29) sont disposés en une rangée transversale au sens de transport.

7. Circuit imprimé, qui est conçu pour le dispositif de transport suivant les revendications 4 à 6 et pour le procédé suivant les revendications 1 et 2, caractérisé en ce qu'au niveau du bord (25) du circuit imprimé (13) qui se trouve devant dans le sens de transport est prévu au moins un trou traversant de contact par aveuglement (18) servant à réfléchir le rayon, ce trou traversant de contact par aveuglement étant disposé, vu dans le sens de transport, suffisamment loin devant la partie câblée (27) du circuit imprimé (13) pour que la vitesse de transport soit nouvellement réglée au moment où la partie câblée (27) atteint la vague de soudure (19).

**FIG.1**

FIG. 2